(19) Europäisches Patentamt
European Patent Office
Office européen des brevets

(11) Veröffentlichungsnummer : **0 016 382**
**B1**

(12) # EUROPÄISCHE PATENTSCHRIFT

(45) Veröffentlichungstag der Patentschrift : **28.04.82**

(21) Anmeldenummer : **80101150.3**

(22) Anmeldetag : **07.03.80**

(51) Int. Cl.³ : **C 30 B 21/02**, C 22 C 1/08, F 01 D 5/28

(54) **Verfahren zur Herstellung von hochtemperaturbeständigen metallischen Bauteilen mit feinporösen Wänden und Anwendung zur Herstellung einer effusionsgekühlten Turbinenschaufel.**

(30) Priorität : **24.03.79 DE 2911714**

(43) Veröffentlichungstag der Anmeldung : **01.10.80 (Patentblatt 80/20)**

(45) Bekanntmachung des Hinweises auf die Patenterteilung : **28.04.82 Patentblatt 82/17**

(84) Benannte Vertragsstaaten : **FR GB IT SE**

(56) Entgegenhaltungen :
**DT - A - 1 964 929**
**FR - A - 2 118 096**

(73) Patentinhaber : **MTU MOTOREN- UND TURBINEN-UNION MÜNCHEN GMBH**
**Dachauer Strasse 665**
**D-8000 München 50 (DE)**

(72) Erfinder : **Betz, Wolfgang, Dr.**
**Aubinger Strasse 139 d**
**D-8000 München 60 (DE)**
Erfinder : **Rossmann, Axel**
**Bachweg 4**
**D-8047 Karlsfeld (DE)**

**EP 0 016 382 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Imprimerie Jouve, 18, rue St-Denis, 75001 Paris, France

# Verfahren zur Herstellung von hochtemperaturbeständigen metallischen Bauteilen mit feinporösen Wänden und Anwendung zur Herstellung einer effusionsgekühlten Turbinenschaufel

Die Erfindung bezieht sich auf ein Verfahren der im Gattungsbegriff des Patentanspruchs 1 bezeichneten Art.

Für dünnwandige Hochtemperaturbauteile, wie z.B. Brennkammern oder Turbinenschaufeln von Gasturbinen, die mit Hilfe eines durchtretenden Kühlmediums nach dem Effusionsprinzip gekühlt werden sollen, sind feinporöse dünne Metallwände wünschenswert. Die Effusionskühlung ist eine besonders effektvolle Kühlung, die z.B. bei Anwendung in Brennkammern zudem den Vorteil bringt, daß das Kühlmedium an dem Verbrennungsprozeß teilnehmen kann, wobei Vorteile durch gleichmäßige Verbrennung denkbar sind (z.B. bessere Verbrennung, dadurch weniger Rißbildung und ein geringerer Anteil von $NO_x$ im Abgas). Bisher werden für effusionsgekühlte dünnwandige Hochtemperaturbauteile Drahtgeflechte und Metallfilze verwendet, die jedoch in einem Temperaturbereich von 1 000 °C und höher keine ausreichende Warmfestigkeit und Oxidationsbeständigkeit aufweisen. Darüber hinaus ist die Formgebung solcher Werkstoffe schwierig und stoffschlüssige Verbindungen (z.B. durch Schweißen oder Löten) sind nur unzureichend möglich, wegen der auftretenden Kerbwirkung und Gefügebeeinflussung. Auch auf dem Gebiet der Herstellung von Turbinenschaufeln ist es bisher nicht gelungen, hochwarmfeste poröse Schichten als Schaufelmantel an einem tragenden Kern zu befestigen.

Neueste Untersuchungen haben nun gezeigt, daß es mit Hilfe der Gerichteten Eutektischen Erstarrung (= GEE) möglich ist, sehr feinporige Filtermembranen mit durchgehender Porösität herzustellen, indem aus einem Stab aus gerichtet eutektisch erstarrtem Material dünne Scheiben quer zur Faserrichtung abgetrennt und dann die Fasern des einen Materials herausgeätzt werden, siehe DE-A-1964929.

Aufgabe der vorliegenden Erfindung ist es, ein vorteilhaftes Verfahren zur Herstellung hochtemperaturbeständiger dünnwandiger metallischer Bauteile mit feinporösen Wänden anzugeben.

Zur Lösung dieser Aufgabe soll ein gattungsgemäßes Verfahren die im Kennzeichnungsteil des Anspruchs 1 aufgeführten Verfahrensschritte aufweisen.

Durch die Einstellung des Temperaturgradienten kann die Richtung der erstarrenden Fasern und damit die Richtung der nachfolgend durch Herausätzen der Fasern oder Nadeln zu erzeugenden Porösität genau eingestellt werden. Von entscheidendem Vorteil ist es, wenn die Aufschmelzung und die gesteuerte Abkühlung des Bauteils bei Schwerelosigkeit und Hochvakuum, d.h. also bei Weltraumbedingungen durchgeführt wird. Dabei kann nämlich der sich aus der Schwerkraft ergebende Einfluß auf die Faserbildung, insbesondere deren Ausrichtung vermieden werden, so daß die bei der gerichteten eutektischen Erstarrung entstehenden Fasern genau entsprechend dem Temperaturgradienten, der bei der Abkühlung eingestellt wird, verlaufen. Die gesteuerte Abkühlung kann durch einseitiges Heizen während des Abkühlungsprozesses unterstützt werden. Die Faserform und -größe kann durch Steuerung der Verfahrensparameter beim Erstarrungsprozeß, z.B. Größe des Temperaturgradienten und/oder durch geeignete Wahl der GEE fähigen Legierung den jeweiligen Forderungen optimal angepaßt werden.

Um während des Aufschmelzprozesses bei Schwerelosigkeit nicht eine Formänderung des Bauteils zu riskieren, soll das Verfahren entsprechend Patentanspruch 2 ausgestaltet werden. Die Schicht aus hochschmelzendem Material dient dabei also als Stützschicht zur Formerhaltung. Solche Stützschichten können z.B. durch Aufdampfen nach dem CVD-Verfahren (= Chemical Vapour Deposition) aufgebracht werden. Auch Oxidschichten, wie sie z.B. in der DE-OS-25-50-858 offenbart sind, können diesem Zweck dienen.

Bei Anwendung des erfindungsgemäßen Verfahrens zur Herstellung einer effusionsgekühlten Turbinenschaufel soll die der gerichteten eutektischen Erstarrung fähige Legierung auf einen tragenden Kern hoher Festigkeit aufgebracht werden, und es sollen nach dem Ätzvorgang, in dessen Verlauf die durchgängige Porösität der Schaufelwand hergestellt wird, unterhalb dieser feinporösen Oberflächenschicht Kühlmittelkanäle eingebracht werden. Die Speisung der Oberflächenschicht (= Schaufelwand) mit dem Kühlmedium kann durch große Längskanäle im tragenden Kern ermöglicht werden. Die Herstellung dieser Kanäle kann entweder entsprechend Patentanspruch 7, oder entsprechend Patentanspruch 8 erfolgen.

Als der gerichteten eutektischen Erstarrung fähiges Material kommen Legierungen der im Patentanspruch 5 gekennzeichneten Typen in Betracht. Dabei werden in der Fachliteratur (vergleiche « Gerichtet erstarrte eutektische Werkstoffe » von W. Kurz und P. R. Sahm, Seite 210, Band 25 (1975) aus der Reihe « Reine und angewandte Metallkunde », herausgegeben von Köster, Springer Verlag Berlin, Heidelberg) unter anderem genannt :

$$(CoCr) - [(Cr, Co)_7C_3]$$

oder

$$(Co) - (TaC)$$

In der beigefügten Zeichnung ist eine Turbinenschaufel dargestellt, die nach dem erfindungsgemäßen Verfahren hergestellt wurde. In der Zeichnung ist der Kern der Schaufel, der aus Material hoher Festigkeit besteht, mit 1 bezeichnet. Zwischen diesem Schaufelkern 1 und der mit durchgängiger Porösität ausgebildeten Schaufelwand 2 befinden sich Kühlmittelkanäle 3, die im Bereich des Schaufelfußes sich zu einem gemeinsamen Kühlmittelkanal vereinigen.

**Ansprüche**

1. Verfahren zur Herstellung von hochtemperaturbeständigen metallischen Bauteilen mit feinporösen Wänden, insbesondere solchen, durch die ein Kühlmedium hindurchdiffundieren kann (Effusionskühlung) gekennzeichnet durch folgende Verfahrensschritte :

a) formgebende Herstellung des Bauteils aus einer der GEE fähigen Legierung (GEE = Gerichtete Eutektische Erstarrung),

b) kurzzeitige Aufschmelzung des Bauteils und gesteuerte Abkühlung, so daß die Erstarrungsfront senkrecht zu den Wandoberflächen verläuft,

c) Herausätzen der entsprechenden Nadeln oder Stäbchen aus dem erstarrten Bauteil.

2. Verfahren nach Anspruch 1, dadurch gekennzeichnet, daß die Aufschmelzung und gesteuerte Abkühlung des Bauteils (Verfahrensschriftt b) bei Schwerelosigkeit und Hochvakuum durchgeführt wird.

3. Verfahren nach Anspruch 1 oder 2, dadurch gekennzeichnet, daß die gesteuerte Abkühlung durch einseitiges Heizen während des Abkühlungsprozesses unterstützt wird.

4. Verfahren nach den Ansprüchen 1 bis 3, dadurch gekennzeichnet, daß das Bauteil vor dem Aufschmelzprozeß mit einem hochschmelzenden Material beschichtet wird, dessen Schmelzpunkt erheblich höher liegt als der des Bauteilmaterials selbst, wobei nach der Erstarrung des Kernmaterials die Schicht wieder entfernt wird.

5. Verfahren nach einem oder mehreren der Ansprüche 1 bis 4, dadurch gekennzeichnet, daß als GEE fähiges Material Legierungen der nachfolgend genannten Typen I, II, III verwendet werden, wobei der in eckige Klammern gesetzte Legierungsbestandteil in Nadel-bzw. Stäbchenform erstarrt und herausgelöst wird :

Typ I : (CoCr) – [$(Cr, Co)_7C_3$].
Typ II : (NiCrCoAl) – [(MC)], MC = Metallcarbide z.B. TaC.
Typ III : (NiCrAl) – [$Cr_3C_2$].

6. Anwendung des Verfahrens nach den Ansprüchen 1 bis 5 zur Herstellung einer effusionsgekühlten Turbinenschaufel, dadurch gekennzeichnet, daß die der GEE fähige Legierung auf einen tragenden Kern hoher Festigkeit aufgebracht wird, und nach dem Ätzvorgang (gemäß Verfahrensschritt c) Anspruch 1) Kühlmittelkanäle unterhalb der feinporösen Oberflächenschicht eingebracht werden.

7. Anwendung nach Anspruch 6, dadurch gekennzeichnet, daß die Kühlmittelkanäle durch Ätzen mit einem speziell auf das Kernmetall wirkenden Ätzmittel hergestellt werden.

8. Anwendung nach Anspruch 6, dadurch gekennzeichnet, daß vor dem Aufbringen der GEE fähigen Schicht auf den tragenden Kern Kühlkanäle in den Kern eingebracht werden und mit hochschmelzendem Material z.B. Keramik ausgefüllt werden und daß nach der Fertigstellung der feinporösen Oberflächenschicht das hochschmelzende Füllmaterial aus den Kühlkanälen durch geeignete Ätzmittel herausgelöst wird.

**Claims**

1. A process for the production of high temperature-resistant metallic components having finepored walls, more particularly components through which a cooling medium can diffuse (effusion cooling), characterised by the following process steps :

a) Moulding of the component from an alloy capable of oriented eutectic solidification,

b) Brief fusion of the component and controlled cooling so that the solidification front extends perpendicularly to the wall surfaces,

c) Etching of the corresponding needles or rodlets from the solidified component.

2. A process according to claim 1, characterised in that the fusion and controlled cooling of the component (process step b) is carried out under weightlessness conditions and high vacuum.

3. A process according to claim 1 or 2, characterised in that the controlled cooling is assisted by unilateral heating during the cooling process.

4. A process according to claims 1 to 3, characterised in that before the fusion process the component is coated with a high-melting material, the melting point of which is much higher than that of the component material itself, the coating being removed after solidification of the core material.

5. A process according to one or more of claims 1 to 4, characterised in that the alloys of the following types I, II, III are used as the material capable of oriented eutectic solidification, the alloy constituent shown in square brackets solidifying in needle or rodlet form and being dissolved out :

Type I : (CoCr) – [$(Cr,Co)_7C_3$].
Type II : (NiCrCoAl) – [(MC)] – MC = metal carbides, e.g. TaC.
Type III : (NiCrAl) – [$Cr_3C_2$].

6. Use of the process according to claims 1 to 5 for the production of an effusion-cooled turbine blade, characterised in that the alloy capable of oriented eutectic solidification is applied to a supporting highstrength core and coolant ducts are introduced beneath the fine-pore surface coating after the etching process (in accordance with process step (c) claim 1).

7. Use according to claim 6, characterised in that the coolant ducts are formed by etching with

an etching agent acting specifically on the core metal.

8. Use according to claim 6, characterised in that prior to the application of the coating capable of oriented eutectic solidification to the supporting core cooling ducts are formed in the core and are filled with high-melting material, e.g. ceramics, and the high-melting filler material is dissolved out of the cooling ducts by suitable etching agents after the production of the fine-pore surface coating.

**Revendications**

1. Procédé pour fabriquer des éléments de construction métalliques à parois finement poreuses, résistant aux températures élevées, notamment ceux à travers lesquels peut diffuser un agent de refroidissement (refroidissement par effusion), caractérisé par les étapes de procédé suivantes :

a) Fabrication de l'élément de construction lui donnant sa forme, à partir d'un alliage capable de SEO (SEO = Solidification eutectique orientée),

b) Fusion de courte durée de l'élément de construction et refroidissement commandé, de sorte que le front de solidification s'étende perpendiculairement aux surfaces de paroi,

c) Elimination par attaque chimique, par rapport à l'élément de construction solidifié, des aiguilles ou baguettes correspondantes.

2. Procédé selon revendication 1, caractérisé en ce que la fusion et le refroidissement commandé de l'élément de construction (étape b du procédé) sont effectués en apesanteur et sous vide poussé.

3. Procédé selon revendication 1 ou 2, caractérisé en ce que le refroidissement commandé est soutenu par chauffage unilatéral pendant le processus de refroidissement.

4. Procédé selon les revendications 1 à 3, caractérisé en ce que l'élément de construction est revêtu avant le processus de fusion d'une couche de matière à point de fusion élevé, dont le point de fusion est considérablement plus élevé que celui de la matière de l'élément de construction elle-même, la couche étant éliminée à nouveau après la solidification de la matière du noyau.

5. Procédé selon une ou plusieurs des revendications 1 à 4, caractérisé en ce qu'on utilise en tant que matières capables de SEO des alliages des types I, II, III indiqués ci-après, la partie constituante des alliages mise entre crochets se solidifiant sous forme d'aiguilles ou de baguettes et étant éliminée par dissolution :

Type I : (CoCr) – [$(Cr,Co)_7C_3$].
Type II : (NiCrCoAl) – [(MC)], MC = Carbure métallique par exemple TaC.
Type III : (NiCrAl) – [$Cr_3C_2$].

6. Application du procédé selon les revendications 1 à 5 pour fabriquer une aube de turbine refroidie par effusion, caractérisée en ce que l'alliage capable de SEO est déposé sur un noyau porteur de résistance élevée et, après l'opération d'attaque chimique (suivant étape c) du procédé de la revendication 1), des conduits d'agent de refroidissement sont ménagés au-dessous de la couche de surface finement poreuse.

7. Application selon revendication 6, caractérisée en ce que les conduits d'agent de refroidissement sont réalisés par attaque chimique avec un produit d'attaque agissant spécialement sur le métal du noyau.

8. Application selon revendication 6, caractérisé en ce qu'avant de déposer l'alliage capable de SEO sur le noyau porteur, des conduits de refroidissement sont ménagés dans le noyau et sont remplis avec une matière à point de fusion élevé, par exemple de la céramique, et en ce qu'après l'achèvement de la couche de surface finement poreuse, la matière de remplissage à point de fusion élevé est éliminée par dissolution, hors des conduits de refroidissement, par des produits d'attaque chimique appropriés.

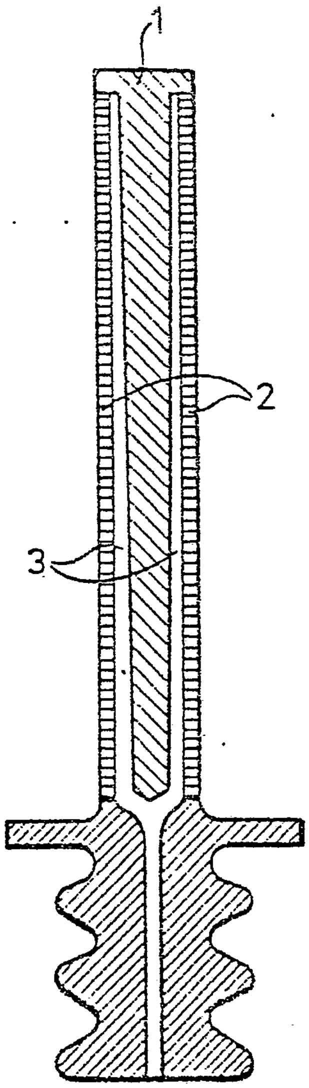
1
2
3